(19) Europäisches Patentamt
European Patent Office
Office européen des brevets

(11) Publication number : **0 393 799 B1**

(12) # EUROPEAN PATENT SPECIFICATION

(45) Date of publication of patent specification : **09.08.95 Bulletin 95/32**

(51) Int. Cl.$^6$ : **G03F 7/16,** G03F 7/26

(21) Application number : **90201328.3**

(22) Date of filing : **10.02.87**

(54) **Vapor deposited photoresists of anionically polymerizable monomers.**

(30) Priority : **10.02.86 US 828107**
**10.02.86 US 828109**

(43) Date of publication of application :
**24.10.90 Bulletin 90/43**

(60) Publication number of the earlier application in accordance with Art. 76 EPC : **0 233 747**

(45) Publication of the grant of the patent :
**09.08.95 Bulletin 95/32**

(84) Designated Contracting States :
**AT BE CH DE ES FR GB GR IT LI LU NL SE**

(56) References cited :
**EP-A- 0 151 372**
**US-A- 4 551 418**

(73) Proprietor : **LOCTITE (IRELAND) Ltd.**
**Whitestown Industrial Estate**
**Tallaght, Co. Dublin 24 (IE)**

(72) Inventor : **Woods, John G.**
**138 Stillorgan Wood,**
**Upper Kilmacud Road**
**Stillorgan, County Dublin (IR)**
Inventor : **Rooney, John M.**
**32 Berkeley Circle**
**Basking Ridge New Jersey 07920 (US)**

(74) Representative : **Marchant, James Ian et al**
**Elkington and Fife**
**Prospect House**
**8 Pembroke Road**
**Sevenoaks, Kent TN13 1XR (GB)**

**EP 0 393 799 B1**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The use of polymeric alkyl cyanoacrylates as resist materials for microlithography is known in the art. For example: IBM Technical Disclosure Bulletin, Vol. 16, No. 11, April 1974, p. 3745, discloses the use of poly methyl alpha cyanoacrylate homopolymers and copolymers as high-speed positive electron-beam resists; Japan Pat. No. 80/21,332 discloses the use of poly butyl cyanoacrylate as a positive-working high sensitivity electron-beam resist; Japan Pat. No. 80/105,244 discloses the use of poly ethyl cyanoacrylate as a positive-working electron-beam resist; U.S. Pat. No. 4,279,984 discloses the use of homopolymers and copolymers of lower alkyl cyanoacrylates as positive-working high energy radiation resists; Eur. Pat. No. 48,899 discloses the use of copolymers of alkyl cyanoacrylates as positive-working resists; Japan Pat. No. 82/87,404 discloses the use of polymeric fluoroalkyl cyanoacrylates as electron beam resists; Japan Pat. No. 83/113,933 discloses the use of copolymers of fluoroalkyl acrylates and alkyl cyanoacrylates as resist materials; Japan Pat. No. 83/108,213 discloses the use of alkyl cyanoacrylate polymers as positive-working radiation resist; and Japan Pat. No. 83/123,727 discloses the use of alkyl cyanoacrylate polymers and azido crosslinking agents as negative-working radiation resists.

In the prior art, the method of applying the resist materials to the substrate is by spin-coating a solution of cyanoacrylate polymer onto the substrate. This procedure requires that the polymer is prepared in advance of the application and then dissolved in a suitable solvent. The solution must be filtered to remove particles of dust before application. After application, the coated substrate must be baked to remove residual solvent. Preparation of cyanoacrylate polymers in large quantities is complicated by high reactivity of the monomers and the strongly exothermic nature of the polymerization.

After polymerization, the polymeric cyanacrylate must then be precipitated to remove impurities such as initiators and inhibitors, a procedure which consumes large amounts of solvent. The purified polymer must then be redissolved in a suitable solvent for spin-coating. This requirement places a limitation on the types of solvent and polymer molecular weights which may be used. For example, poly methyl cyanoacrylate is soluble in very few solvents, such as nitromethane and dimethylformamide. In general, it is very difficult to spin-coat films of cyanoacrylate polymers with molecular weights in excess of 1,000,000 as stated in U.S. Pat 4,279,984, Col. 2, lines 23-28. However, films formed from polymers below this molecular weight are easily removed by common organic solvents necessitating shortened developing times as stated in U.S. Pat 4,279,984, Col. 3, lines 60-68, and Col. 4, lines 1 - 9. A further disadvantage or the spin-coating process is that attempts to coat a patterned substrate resulting in uneven coating thicknesses i.e., the coating is thicker in depressed regions than in raised regions. One method of overcoming this problem involves the use of multilayer resists. However, applying two or three layers and using two or three image development steps increases the cost and complexity of the lithographic process.

In the prior art, the method of imaging the cyanoacrylate based resists involved spin-coating a solution of cyanoacrylate polymer onto the substrate and exposing the coated surface to high-energy radiation through a mask or to steered high-energy beams. In the case of positively imaged resists, the exposed portions of the coating are then removed by treatment with solvent, and in the case of a negatively imaged resist the unexposed portions are removed by solvent. This solvent development step inevitably results in some degree of distortion of that portion of the coating which is to remain on the substrate and form a relief image.

Other methods for forming resist films on substrates are as follows:

"Instrument and Experimental Techniques," Vol. 23 (1980), pp. 1521-1523 (Gusakov, et al.), discloses an apparatus for depositing organic films from the vapor state in response to UV light. The method disclosed for depositing the film requires the use of the apparatus which is a high precision complex apparatus. In accordance with the teachings of this document, the substrate to which the film is to be applied is placed in a chamber which is placed under vacuum in order to eliminate the presence of oxygen and/or water. A small flow of the organic monomer is passed through the chamber, under vacuum, in order to provide a source of monomer for deposition. Additionally, because of the nature of the apparatus, the apparatus requires quartz windows for the introduction of ultraviolet light or such other actinic radiation so as to initiate and effect polymerization. In addition, this process requires high purity organic monomer, an inert (or at least oxygen and water free) atmosphere and must not employ heat.

Patent Abstracts of Japan, Vol. 6, No. 259 (E-149) (1137) (1982) (Yasuo), discloses a method for depositing a resist film on a substrate by plasma polymerization of monomer on a substrate surface. The property and/or thickness of the resist film deposited may be regulated by changes to the flow rate of the gas, the degree of vacuum, the composition of the high molecular monomer gas and/or varying the high-frequency output. This method also requires a high precision, complex apparatus in order to conduct the method of manufacturing the resist film.

"IBM Technical Disclosure Bulletin," Vol. 19, No. 7 (1976) - Hiraoka discloses the surface photopolymerization of methacrylic anhydride and dimethacrylimides to form very thin polymer film for lithographic applications. The polymerization of the monomer on the substrate surface is accomplished through the use of near ultraviolet light. The disclosure states that although the technique can be used with solutions of monomer, it is more advantageous wherein surface photopolymerization is achieved from a gas phase on the substrate surface. There is very little disclosure as to the type of apparatus or other environmental factors that may be involved. This system does however require the use of a near UV light source within a glass vessel.

European Patent Application Publication No. 0049884 discloses a process for forming a fluoroalkyl acrylate polymer film on a substrate by plasma polymerization. This plasma polymerization deposition method employs a complex high precision apparatus for the formation of the plasma and for the regulation of the atmosphere within the plasma polymerization chamber. The polymer film so formed is indurable to dry etching. Thus, a pattern resist film may be prepared by irradiating the film with high energy rays to form a latent pattern and subsequently developing the same.

Methods are also known for forming images on a substrate by directly polymerizaing monomers imagewise onto areas of the substrate previously exposed to radiation.

European Patent Application No. 0136421-Hiraoka discloses a microlithographic process characterised by confining a monomer vapor in a closed chamber containing a substrate and exposing the monomer vapor to a patterned beam of ions to cause a patterned-exposed polymer film to be deposited on the surface of the substrate. Those areas of the substrate surface wherein the patterned-exposed polymerization did not occur may subsequently be etched using an oxygen plasma so as to form an etched image on the substrate surface.

U.S. 4,551,418 - Hult, et al., discloses a method for creating negative relief images on a substrate by a process comprising coating a substrate with an etchable substrate and a photoinitiator. Subsequently, exposing the photoinitiator treated surface (image-wise) to actinic radiation so as to activate the cationic polymerization catalyst in the exposed areas and thereafter exposing said substrate to a polymer vapor of a cationically polymerizable monomer so as to affect polymerization thereof in the activated areas. The polymer so formed is resistant to plasma etching such that the substrate may then be placed in a plasma environment and the unexposed areas of the film may be etched by plasma treatment to produce a high resolution negative tone relief image.

U.S. 4,081,276 - Crivello discloses a method of forming an image on the surface of a substrate by treating the substrate with a photoinitiator, exposing the treated surface to radiant energy (optionally in an image-wise fashion) so as to cause the formation of a cationic polymerization catalyst on the exposed substrate surface. The substrate may then be contacted with a cationically polymerizable organic material resulting in the formation of an adherent organic film on the exposed substrate surface. This method may also be employed to create a negative photoresist by applying a mask on the treated substrate prior to exposing the photoinitiator to ultraviolet light.

International Application No. WO 85/02030 Brault, et al. discloses a method for preparing graft polymerized $SiO_2$ lithographic masks. The method comprises applying a resist coating (either positive or negative resist) to a substrate via conventional methods, i.e., spin coating, and therafter irradiating the treated surface in order to generate organic free radicals. The reactive resist polymers subsequently exposed to an oxygen gas containing atmosphere in order to convert at least a substantial portion of the free radicals to a class of peroxides or hydroperoxides. These peroxides or hydroperoxides are later thermally decomposed to produce organic free radicals which are capable of reacting with an organic monomer, preferably a silicon-containing organic monomer to graft polymerize the same thereon.

Cyanoacrylate monomer vapors have recently been utilized as a fingerprint developer. A detailed discussion of such techniques is included in U.S. No. 4,550,041.

## SUMMARY OF THE INVENTION

The present invention provides a method for applying a polymeric resist coating of very high molecular weight to a suitable substrate without the necessity of elaborate purification steps and for ensuring adequate coverage of raised regions in three-dimensionally patterned substrates.

The invention comprises exposing the substrate to be coated to the vapor of an anionically polymerizable monomer of the formula:

$$CHR{=}CXY \qquad I,$$

where X and Y are strong electron withdrawing groups and R is H or, provided that X and Y are both -CN, $C_1$-$C_4$ alkyl for sufficient time to deposit a polymerizable coating thereon. Particularly preferred monomers are 2-cyanoacrylate esters. The monomer condenses and polymerizes on the surface of the substrate to give a highly uniform high molecular weight polymeric coating which is useful as a resist coating in lithographic processes employing plasma or acid etch techniques.

The method is especially used in microlithographic processes for producing semiconductor devices on silicon chips.

A further aspect of the invention comprises a process in which an etchable substrate is coated with polymer as described above; the coated substrate is subsequently imaged using high energy radiation; the image is developed by conventional solvent development processes; the image is etched using a suitable plasma or acid etching process, and the resist coating is subsequently removed by heating the coating to a temperature above the polymer depolymerization temperature.

A still further aspect of the invention comprises a substrate etchable by acid or plasma etching processes which has been coated with a high molecular weight cyanoacrylate polymer formed by vapor deposition of cyanoacrylate monomer on the substrate.

The inventive process can be utilized to produce uniform etch resistant coatings of less than 0.1 micron thick.

## DETAILED DESCRIPTION OF THE INVENTION

The preferred monomers for use in the inventive process are cyanoacrylate esters, vinylidene cyanide and dialkyl methylene malonates. The well known cyanoacrylate monomers are especially preferred and many are commercially available as "instant" adhesives. The cyanoacrylate monomers have the formula:

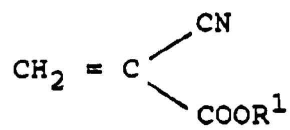

wherein $R^1$ represents a hydrocarbyl or substituted hydrocarbyl group such as a straight chain or branched chain alkyl group having 1 to 12 carbon atoms (which may be substituted with a substituent such as a halogen atom or an alkoxy group) a straight chain or branched chain alkenyl group having 2 to 12 carbon atoms, a straight chain or branched chain alkynyl group having 2 to 12 carbon atoms, a cycloalkyl group, an aralkyl group or an aryl group. Specific examples of the groups for $R^1$ are a methyl group, an ethyl group, an n-propyl group, an isopropyl group, an n-butyl group, an isobutyl group, a pentyl group, a hexyl group, an allyl group, a methallyl group, a crotyl group, a propargyl group, a cyclohexyl group, a benzyl group, a phenyl group, a cresyl group, a 2-chloroethyl group, a 3-chloropropyl group, a 2-chlorobutyl group, a trifluoroethyl group, a 2-methoxyethyl group, a 3-methoxybutyl group and a 2-ethoxyethyl group.

Preferred cyanoacrylate are alkyl cyanoacrylates having 1-6 carbon atoms. Ethyl and isobutyl cyanoacrylates are especially preferred.

The monomer vapors are most suitably generated from the monomers. This may be done at ambient temperatures and pressures but it is generally preferred to heat the monomers and/or reduce the atmospheric pressure above the monomer generated chamber in order to generate sufficient concentrations of vapor to accomplish the polymer deposition on the substrate in a reasonable time.

As an alternative to vapor generation from monomers, cyanoacrylate polymers which are heated above their depolymerization temperatures, typically about 150°C, may be used as a monomer vapor source. In particular, vapors generated from thermal removal of resist coatings may be recirculated, a feature which has significant environmental advantages.

Concentrated cyanoacrylate monomer vapors may also be generated by other techniques well known in the fingerprint development art and summarized in U.S. 4,550,041.

While the cyanoacrylate ester monomers are preferred because of their ready availability, better known handling properties and low depolymerization temperatures, other anionically polymerizable monomers encompassed within Formula I above may also be usefully employed. As used herein, the term "strong electron withdrawing groups" refers to groups which are more electron withdrawing than halo. Generally, the electron withdrawing groups X and Y may be independently selected from $-SO_2R$; $SO_3R$; -CN; $-COOR^1$ and $-COR^2$, where $R^1$ is as previously defined and $R^2$ is H or hydrocarbyl, preferably $C_1$-$C_{12}$ hydrocarbyl. Vinylidene cyanide, in particular, is known to give especially insoluble polymeric products. Vinylidene cyanide and its lower alkyl homologs may be obtained, for instance, by processes described in U.S. 2,313,501; 2,502,412; 2,514,387; 2,663,725, and 2,665,298, the disclosures of which are incorporated herein by reference. Other anionically polymerizable monomers within the scope of Formula I include: dialkyl methylene malonates as described in U.S. 2,330,033; 3,197,318; 3,221,745 and 3,523,097; acylacrylonitriles as described in GB 1,168,000; and vinyl sulfinates and sulfonates of the formula $CH_2$=CXY where X is $-SO_2R^2$ or $-SO_3R^2$ and Y is -CN, $-COOR^2$, $-COCH_3$, $-SO_2R^2$ or $-SO_3R^2$, as described in U.S. 2,748,050.

Virtually, any substrate upon which a polymeric image is desired may be utilized in the inventive process. Most advantageously, the substrates will be ones which undergo subsequent acid or plasma etching during which the polymer coating serves as an etch resist. Suitable substrate materials include silicon dioxide, including $SiO_2$ coated silicon, metallic oxides, and glass, all of which may be etched by plasma or acid etching processes. Metallic substrates which can be etched by acid processes, such as copper coated epoxy/glass boards used in printed circuit board manufacture and metal printing plates may also be utilized in the inventive process. Where the inventive process is used to produce an etch resist, the resist coating may be removed after etching by heating the substrate above the depolymerization temperature of the polymer, preferably under vacuum.

When the polymer is deposited as a uniform coating on the substrate, subsequent imaging and development steps are those conventional in the art for cyanoacrylate resist materials. Typically a high energy source such as a deep UV source (wavelength below 300 nm) or an ionizing radiation source (such as electron beam, X-ray or gamma ray) is used to produce the image. Either direct write or photomask techniques may be employed to imagewise expose the substrate. After exposure, the image is developed by conventional solvent development techniques.

The preferred substrate is $SiO_2$ coated silicon, e.g., the silicon chips conventionally used in preparation of semiconductor devices. Most suitably, this substrate is etched by a plasma etching process. Surprisingly, the high molecular weight cyanoacrylate polymers produced by the inventive process have a significantly greater etch resistance than spin coated cyanoacrylate polymer resists.

Very high molecular weight polymer is formed by the inventive process. This is evidenced by the inability of aggressive solvents such as dichloromethane to dissolve the coating. As noted above, however, the coating is readily removed by heating above the depolymerization temperature of the polymer. For cyanoacrylate polymers, the depolymerization temperature is only about 150-200°C so the coating removal step will not harm the typical substrate.

If the substrate surface is inherently active for inducing anionic polymerization of cyanoacrylates, or such other monomer within Formula I as may be employed, no surface treatment will be necessary to obtain the desired high molecular weight uniform coatings. In certain cases, however, where the substrate is slightly acidic or neutral, it is necessary to activate the surface with a basic liquid or vapor which is substantially removed before exposing the substrate to the monomer vapor. Suitable activators include the known initiators for anionic or zwitterionic polymerization of alkyl cyanoacrylates. Especially suitable activators are organic amines and phosphines.

Only trace amounts of surface activator are necessary. Mirror finish substrates may be repolished, e.g., with a suitable tissue, after application of these compounds and still retain sufficient activator and acid generator to give sharply imaged resists after irradiation and exposure to monomer vapor.

The invention is further illustrated by the following non-limiting examples.

Example 1:

Polished silicon wafers 3 inches in diameter were treated with activator as shown in Table 1. The activator was brushed uniformly across the wafer surface and allowed to evaporate. The wafer was then polished with a paper tissue to restore the mirror finish, and mounted with the treated surface covering the opening of a 250 ml polyethylene beaker into which 0.2 gram of ethyl cyanoacrylate monomer had been placed. The beaker was placed on top of a Tecam DB-3Dri-Block heating apparatus maintained at a block temperature of 85°C. After the time indicated in Table 1 had elapsed, the wafer was removed.

Lines were mechanically inscribed on the coated wafers to expose the wafer surfaces and coating depths were measured with a Nanospec polarized optical system. In Table 1, coating thicknesses are reported for the center of the wafer. The deposited coating was then carefully removed with a scalpel blade and checked for solubility. The coatings were found to be substantially insoluble in dichloromethane, indicating the formation of extremely high molecular weight poly(ethyl cyanoacrylate).

The amount of polymeric cyanoacrylate deposited was determined by weighing the wafers on a micro-balance before and after removal of the coating.

TABLE 1

| Activator: | Amt. g: | Expos. Time, Min: | Coating Thick-ness, µ | Coating Weight, mg: |
|---|---|---|---|---|
| None | -- | 10 | 0 | 0 |
| N,N,N,'N'-Tetramethyl Ethylene Diamine (TMEDA) | 0.1 | 3 | 0.77 | 3.0 |
| N,N-Diethyl Trimethyl-silyl Amine (DTMSA) | 0.1 | 6 | 2.0 | 7.5 |
| Triphenyl Phosphine: Dichloromethane (1:3 mixture) | 0.3 | 8 | 1.7 | 5.5 |

Example 2:

The experiment described in Example 1 was repeated using 0.1g TMEDA activator and the cyanoacrylate monomers specified in Table 2.

TABLE 2

| Monomer: | Exposure Time, Min: | Film Thickness, µ |
|---|---|---|
| Allyl cyanoacrylate | 3 | 0.3 |
| Methyl cyanoacrylate | 8 | 2.8 |

Example 3:

The experiment described in Example 1 was repeated using 0.1g TMEDA activator and ethyl cyanoacrylate. At specified intervals the wafer was removed from the vapor and weighed on a microbalance. The amount of polymer deposited on the wafer after various exposure times is recorded in Table 3.

TABLE 3

| Exposure Time, min: | Weight Increase, mg: |
|---|---|
| After Activator Treatment | 0 |
| 2 | 2.6 |
| 4 | 4.4 |
| 6 | 6.3 |

Example 4:

A polished silicon wafer 3 inches in diameter was mounted perpendicular to the shaft of a shirring motor with a variable speed adjustment. The surface of the wafer was activated with TMED according to the procedure of Example 1. The wafer was then rotated at a speed of about 100 revolutions per minute and lowered into a 1 liter polyethylene beaker containing 0.2 grams of ethyl cyanoacrylate monomer. The wafer was lowered to a depth of about 10cm above the bottom of the beaker which had been heated to 85° as described in Example 1. After 3 minutes exposure, the wafer was removed and the thickness of the deposited polymeric coating was measured at 12 points across the surface of the wafer. A uniform coating of 0.6 microns had been deposited with a variation of less than 0.003 microns across the surface.

Example 5:

The experiment outlined in Example 4 was repeated except that the beaker contained 0.4 grams of ethyl cyanoacrylate, the rotation speed was 35 r.p.m. and the exposure time was 4 minutes. A uniform coating of 0.15 microns was deposited with a variation of less than 0.006 microns across the surface.

Example 6:

The experiment outlined in Example 1 was repeated using TMEDA and ethyl cyanoacrylate. The substrate was a silicon wafer on which a pattern of relief images had been etched. The coated wafer was then sectioned and examined under a scanning electron microscope. The coating was found to follow the contours of the substrate more closely than a comparable coating applied by spinning from solution.

Example 7:

Silicon wafers were coated with the polymeric cyanoacrylate esters listed in Table 4 by each of two methods: by a conventional spin-coating (SC) technique in which high molecular weight polycyanoacrylates were dissolved in nitromethane and applied to the wafer surface; and by the vapor-coating (VC) technique outlined in Example 4. Coated wafers were then placed in a platen plasma reactor and etched under a CF4: CHF3: Ar atmosphere. The rate of resist etching was measured on each sample together with the rate of $SiO_2$ etching and the results are summarized in Table 4.

TABLE 4

| Resist Polymer Ester (Coating Method) | $SiO_2$ Etch Rate A/Min | Resist Etch Rate A/Min | Etch Ratio |
|---|---|---|---|
| Ethyl (SC) | 79 | 134 | 1.70 |
| Ethyl (VC) | 79 | 53 | 0.67 |
| i-Butyl (SC) | 85 | 100 | 1.18 |
| i-Butyl (VC) | 73 | 38 | 0.52 |
| n-Butyl (SC) | 88 | 104 | 1.18 |
| n-Butyl (VC) | 71 | 51 | 0.72 |
| Allyl (SC) | 71 | 43 | 0.61 |
| Allyl (VC) | 60 | 36 | 0.60 |

For dry-process compatibility in microcircuit fabrication, it is desirable that a resist material etch at a lower rate than $SiO_2$, i.e., that the ratio cited in Table 4 be less than 1.0. From the data it can be seen that resists deposited by the method of this invention are superior to those deposited by the convention technique.

## Claims

1. A method of providing a resist coating on an acid or plasma etchable substrate comprising exposing the substrate to the vapor of an anionically polymerizable monomer of the formula:

   $$CHR=CXY$$

   where X and Y are strong electron withdrawing groups and R is H or, provided X and Y are both cyano groups, $C_1$-$C_4$ alkyl, for sufficient time to deposit a polymerized coating of the monomer on the surface of the substrate, said substrate surface being active for inducing anionic polymerization of the monomer.

2. A method as in claim 1 where the monomer is selected from 2-cyano-acrylate esters, vinylidene cyanide and its $C_1$-$C_4$ alkyl homologs, dialkyl methylene malonates, acylacrylonitriles, and vinyl sulfinates or sulfonates of the formula $CH_2=CXY$ where X is $-SO_2R^2$ or $SO_3R^2$ and Y is selected from -CN, $-COOR^2$, $-COCH_3$, $-SO_2R^2$ or $-SO_3R^2$, and $R^2$ is H or hydrocarbyl.

3. A method as in claim 2 where the monomer is cyanoacrylate ester.

4. A method as in claim 1 wherein the substrate is $SiO_2$ coated silicon.

5. A method as in claim 1 wherein the substrate has a surface activated to induce polymerization of the monomer by treatment with an initiator for anionic or zwitterionic polymerization of alkyl cyano-acrylates.

6. A method as in claim 5 wherein the initiator is an organic amine or phosphine.

7. A method as in claim 1 wherein the polymerized coating is less than 0.1 μm thick.

8. A method of providing an image-wise etched surface on a substrate etchable by plasma or acid etching techniques comprising (a) coating the surface of the substrate with a polymeric resist coating by exposing the substrate to the vapor of an anionically polymerizable monomer of the formula:

$$CHR{=}CXY$$

where X and Y are strong electron withdrawing groups and R is H or, provided X and Y are both cyano groups, $C_1$-$C_4$ alkyl, said substrate surface being active for inducing anionic polymerization of the monomer; (b) image-wise exposing the coated surface to deep UV or ionizing radiation; (c) developing the image; (d) etching the substrate; and (e) removing the resist coating by heating the coating to a temperature above the polymer depolymerization temperature.

9. A method as in claim 8 wherein the monomer is cyanoacrylate ester.

10. A method as in claim 8 wherein the substrate is silicon coated with $SiO_2$.

11. A method as in claim 8 wherein the substrate has a surface activated to induce polymerization of the monomer by treatment with an initiator for anionic or zwitterionic polymerization of alkyl cyanoacrylates.

12. A method as in claim 11 wherein the initiator is an organic amine or phosphine.

13. A method as in claim 8 wherein said image is developed by solvent washing.

14. A method of claim 8 wherein said etching is accomplished by plasma or acid etching techniques.

## Patentansprüche

1. Verfahren zur Bereitstellung eines Resistüberzugs auf einem Säure- oder Plasma-ätzbarem Substrat, umfassend Aussetzen des Substrats gegenüber dem Dampf eines anionisch polymerisierbaren Monomeren der Formel

$$CHR{=}CXY,$$

worin X und Y starke elektronenziehende Gruppen sind und R für H steht oder mit der Maßgabe, daß X und Y beide für Cyanogruppen stehen, für $C_1$-$C_4$-Alkyl steht, lange genug, um einen polymerisierten Überzug des Monomeren auf der Oberfläche des Substrats abzuscheiden, wobei die genannte Subtratoberfläche aktiv ist zum Auslösen einer anionischen Polymerisation des Monomeren.

2. Verfahren nach Anspruch 1, bei dem das Monomer ausgewählt wird aus 2-Cyanoacrylatestern, Vinylidencyanid und seinen $C_1$-$C_4$-Alkylhomologen, Dialkylmethylenmalonaten, Acylacrylnitrilen und Vinylsulfinaten oder -Sulfonaten der Formel $CH_2{=}CXY$, worin X für $-SO_2R^2$ oder $SO_3R^2$ steht und Y ausgewählt wird aus -CN, $-COOR^2$, $-COCH_3$, $-SO_2R^2$ oder $-SO_3R^2$ und $R^2$ für H oder Hydrocarbyl steht.

3. Verfahren nach Anspruch 2 bei dem das Monomer Cyanoacrylatester ist.

4. Verfahren nach Anspruch 1, bei dem das Substrat $SiO_2$-beschichtetes Silicium ist.

5. Verfahren nach Anspruch 1, bei dem das Substrat eine Oberfläche aufweist, die aktiviert ist, um die Polymerisation des Monomeren durch Behandeln mit einem Starter für anionische oder zwitterionische Polymerisation von Alkylcyanoacrylaten auszulösen.

6. Verfahren nach Anspruch 5 bei dem der Starter ein organisches Amin oder Phosphin ist.

7. Verfahren nach Anspruch 1, bei dem der polymerisierte Überzug weniger als 0,1 $\mu$m dick ist.

8. Verfahren zum Bereitstellen einer bildweise geätzten Oberfläche auf einem Substrat, das durch Plasma- oder Säureätztechniken ätzbar ist, umfassend (a) Überziehen der Oberfläche des Substrats mit einem polymeren Resistüberzug, indem das Substrat gegenüber dem Dampf eines anionisch polymerisierbaren Monomeren der Formel

$$CHR{=}CXY,$$

ausgesetzt wird, worin X und Y starke elektronenziehende Gruppen sind und R für H steht oder mit der

Maßgabe, daß X und Y beide für Cyanogruppen stehen, für $C_1$-$C_4$-Alkyl steht, wobei die genannte Substratoberfläche zum Auslösen einer anionischen Polymerisation des Monomeren aktiv ist, (b) bildweise Exposition der überzogenen Oberfläche gegenüber ferner UV- oder ionisierender Strahlung, (c) Entwickeln des Bildes, (d) Ätzen des Substrats und (e) Entfernen des Resistüberzugs durch Erhitzen des Überzugs auf eine Temperatur oberhalb der Polymer-Depolymerisationstemperatur.

**9.** Verfahren nach Anspruch 8, bei dem das Monomer Cyanoacrylatester ist.

**10.** Verfahren nach Anspruch 8, bei dem das Substrat $SiO_2$-beschichtetes Silicium ist.

**11.** Verfahren nach Anspruch 8, bei dem das Substrat eine Oberfläche besitzt, die aktiviert ist, um die Polymerisation des Monomeren durch Behandeln mit einem Starter für anionische oder zwitterionische Polymerisation von Alkylcyanoacrylaten auszulösen.

**12.** Verfahren nach Anspruch 11, bei dem der Starter ein organisches Amin oder Phosphin ist.

**13.** Verfahren nach Anspruch 8, bei dem das genannte Bild durch Lösungsmittelwaschen entwickelt wird.

**14.** Verfahren nach Anspruch 8, bei dem das genannte Ätzen durchgeführt wird durch Plasma- oder Säureätztechniken.

## Revendications

**1.** Un procédé pour former un revêtement de réserve sur un substrat attaquable par un acide ou un plasma, consistant à exposer le substrat à la vapeur d'un monomère anioniquement polymérisable de la formule :

$$CHR=CXY$$

où X et Y sont des groupes électro-attractifs forts et R est H ou, si X et Y sont tous deux des groupes cyano, un groupe alkyle en $C_1$-$C_4$, pendant un temps suffisant pour déposer un revêtement polymérisé du monomère sur la surface du substrat, ladite surface du substrat étant active pour provoquer la polymérisation anionique du monomère.

**2.** Un procédé selon la revendication 1, dans lequel le monomère est choisi parmi les esters 2-cyanoacryliques, le cyanure de vinylidène et ses homologues à groupement alkyle en $C_1$-$C_4$, les méthylène-malonates de dialkyle, les acylacrylonitriles et les vinylsulfinates ou vinylsulfonates de la formule $CH_2=CXY$ où X est $-SO_2R^2$ ou $SO_3R^2$ et Y est choisi parmi -CN, $-COOR^2$, $-COCH_3$, $-SO_2R^2$ ou $-SO_3R^2$ et $R^2$ est H ou un groupe hydrocarbyle.

**3.** Un procédé selon la revendication 2, dans lequel le monomère est un ester cyano-acrylique.

**4.** Un procédé selon la revendication 1, dans lequel le substrat est du silicium revêtu de $SiO_2$.

**5.** Un procédé selon la revendication 1, dans lequel la surface du substrat a été activée pour provoquer la polymérisation du monomère par traitement avec un initiateur de polymérisation anionique ou zwitterionique de cyanoacrylates d'alkyle.

**6.** Un procédé selon la revendication 5, dans lequel l'initiateur est une amine ou phosphine organique.

**7.** Un procédé selon la revendication 1, dans lequel le revêtement polymérisé a une épaisseur inférieure à 0,1 μm.

**8.** Un procédé pour former une surface gravée selon une image sur un substrat attaquable par des techniques de gravure au plasma ou à l'acide consistant à (a) recouvrir la surface du substrat avec un revêtement de réserve polymère en exposant le substrat à la vapeur d'un d'un monomère anioniquement polymérisable de la formule

$$CHR=CXY$$

où X et Y sont des groupes électro-attractifs forts et R est H ou, si X et Y sont tous deux des groupes cyano, un groupe alkyle en $C_1$-$C_4$, ladite surface du substrat étant active pour provoquer la polymérisation

anionique du monomère ; (b) exposer selon une image la surface revêtue à un rayonnement ionisant ou ultraviolet lointain ; (c) développer l'image ; (d) attaquer le substrat ; et (e) éliminer le revêtement de réserve en chauffant le revêtement à une température supérieure à la température de dépolymérisation du polymère.

**9.** Un procédé selon la revendication 8, dans lequel le monomère est un ester cyano-acrylique.

**10.** Un procédé selon la revendication 8, dans lequel le substrat est du silicium revêtu de $SiO_2$.

**11.** Un procédé selon la revendication 8, dans lequel la surface du substrat a été activée pour provoquer la polymérisation du monomère par traitement avec un initiateur de polymérisation anionique ou zwitterionique de cyanoacrylates d'alkyle.

**12.** Un procédé selon la revendication 11, dans lequel l'initiateur est une amine ou phosphine organique.

**13.** Un procédé selon la revendication 8, dans lequel ladite image est développée par lavage au solvant.

**14.** Un procédé selon la revendication 8, dans lequel ladite attaque est effectuée par des techniques de gravure au plasma ou à l'acide.